(19) Europäisches Patentamt
European Patent Office
Office européen des brevets

(11) **EP 2 249 455 A1**

(12) **EUROPEAN PATENT APPLICATION**
published in accordance with Art. 153(4) EPC

(43) Date of publication:
**10.11.2010 Bulletin 2010/45**

(51) Int Cl.:
*H02J 7/10* (2006.01)    *G01R 31/36* (2006.01)
*H01M 10/48* (2006.01)

(21) Application number: **08721084.5**

(22) Date of filing: **29.02.2008**

(86) International application number:
**PCT/JP2008/053664**

(87) International publication number:
**WO 2009/107236 (03.09.2009 Gazette 2009/36)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Techno Core International Co., Ltd.**
**Hyogo 660-0083 (JP)**

(72) Inventors:
• **TAKAOKA, Hiromi**
**Amagasaki-shi**
**Hyogo 660-0083 (JP)**

• **KITAMURA, Shinzo**
**Kobe-shi**
**Hyogo 654-0037 (JP)**
• **ATSUTA, Toshio**
**Kobe-shi**
**Hyogo 654-0037 (JP)**

(74) Representative: **Schön, Christoph et al**
**Kroher-Strobel**
**Rechts- und Patentanwälte**
**Bavariaring 20**
**80336 München (DE)**

(54) **CHARGING DEVICE AND QUALITY JUDGING DEVICE OF PACK CELL**

(57)    [PROBLEMS] A charging apparatus and a quality judging apparatus for a packed battery should be configured to prevent reduction of charging/discharging performance at the time of charging the packed battery, to improve reliability of the packed battery, and to secure safety of the packed battery.

[MEANS FOR SOLVING PROBLEMS] A charging controller (43) is provided with a maximum value specifying means (62) specifying a maximum value $v_{maxon}$ of a cell voltage value based on a dispersion degree $\sigma$ of a secondary cell (10a), a third judging means (63) judging whether or not the maximum value $v_{maxon}$ of the cell voltage value, which is specified by the maximum value specifying means (62), reaches a permissible cell voltage value $v_c$ or not, and a charging voltage value change means (64) changing a charging voltage applied by a voltage supply means (41) based on a voltage difference between the maximum value $v_{maxon}$ of the cell voltage value and the permissible cell voltage value $v_c$ when the third judging means (63) judges that the maximum value $v_{maxon}$ of the cell voltage value is larger than the permissible cell voltage value $v_c$.

Fig. 1

EP 2 249 455 A1

**Description**

Technical Field

The present invention relates to an art of a charging apparatus and a quality judging apparatus for a packed battery, especially an art of a charging apparatus and a quality judging apparatus for a packed battery in which a plurality of secondary cells are connected in series.

Background Art

A secondary cell, such as a nickel-cadmium cell, a nickel-hydrogen cell and a lithium-ion cell, can be used repeatedly by repeating a cycle of charge and discharge.
However, when the secondary cell is charged several times, because of overcharging, deterioration of electrolyte or electrode plate of the secondary cell, or the like, the charge capacity becomes smaller than that of the initial, whereby the deterioration of the secondary cell progresses and the secondary cell becomes unable of being used finally.
The main cause of the deterioration of the secondary cell is the overcharging. Then, there are well known methods for charging while preventing the overcharging (for example, see the Patent Literatures 1 to 4).

 Patent Literature 1: the Japanese Patent No. 3913443
 Patent Literature 2: the Japanese Patent No. 3539123
 Patent Literature 3: the Japanese Patent No. 3430439
 Patent Literature 4: the Japanese Patent No. 3752249

Disclosure of Invention

Problems to Be Solved by the Invention

However, when the same charge voltage is impressed to a packed battery in which a plurality of secondary cells are connected in series, the dispersion of the secondary cells in quality causes excess of voltage in one or several secondary cells, whereby the overcharging is caused. Then, even if the other secondary cells are normal, the one or several deteriorated secondary cells may reduce charging/discharging performance of the whole packed battery so as to spoil the reliability of the packed battery. Very complicated control is required for individual control of voltage value of each secondary cell, thereby increasing the cost.
The safety at the time of charging of the packed battery must be secured. Then, the voltage value of each of the secondary cells constituting the packed battery must be less than fixed value. For example, when each of the secondary cells is constructed by a lithium-ion cell, the value of voltage impressed to each of the secondary cells must not be larger than the maximum value of charge-on voltage determined by a manufacturer of the packed battery.
In consideration of the above problems, the purpose of the present invention is to provide a charging apparatus and a quality judging apparatus for a packed battery, with which reduction of charging/discharging performance at the time of charging the packed battery can be prevented, reliability of the packed battery can be improved and safety of the packed battery can be secured.

Means for Solving the Problems

In a first aspect of the present invention, a charging apparatus for a packed battery charges the packed battery in which a plurality of secondary cells are connected in series, and the charging apparatus comprises: a voltage supply means supplying a predetermined charging voltage to the packed battery; a cell voltage value detection means detecting cell voltage values of the respective secondary cells constituting the packed battery; and a charging control means controlling the charging voltage supplied to the packed battery. The charging control means comprises: a dispersion degree calculation means calculating a dispersion degree of the secondary cells based on the cell voltage values detected by the cell voltage value detection means; a maximum value specifying means specifying the maximum value of the cell voltage value based on the dispersion degree calculated by the dispersion degree calculation means; a judging means judging whether or not the maximum value of the cell voltage value specified by the maximum value specifying means reaches a preset permissible cell voltage value; and a charging voltage value change means changing the charging voltage impressed by the voltage supply means based on a voltage difference between the maximum value of the cell voltage value and the permissible cell voltage value when the judging means judges that the maximum value of the cell voltage value is larger than the permissible cell voltage value.
In the charging apparatus for the packed battery according to the present invention, the cell voltage value detection means includes detecting terminals detecting terminal cell voltage values of the respective secondary cells constituting the packed battery, and the cell voltage value of the secondary cell as a target to be detected is detected based on a potential difference between the terminal cell voltage value of the secondary cell as the target to be detected and the terminal cell voltage value of the secondary cell at the lower potential side of the secondary cell as the target to be detected.

The charging apparatus for the packed battery according to the present invention further comprises a current value detection means detecting a current value of current flowing in the packed battery. The charging control means comprises: a voltage value switch means switching the charging voltage for the packed battery between a predetermined charging voltage value, which exceeds a full-charge balanced voltage value and does not reach an irreversible chemical reaction region, and a check voltage value determined in correspondence to the full-charge balanced voltage value; an internal resistance value calculation means calculating an internal resistance value based on the cell voltage value of the secondary cell detected by the cell voltage value detection means in the case that the predetermined charging voltage value is impressed to the packed battery by the switching of the voltage value switch means, based on the cell voltage value of the secondary cell detected by the cell voltage value detection means in the case that the check voltage value is impressed to the packed battery by the switching of the voltage value switch means, and based on the current value detected by the current value detection means; and a state-of-health calculation means calculating a state of health of the secondary cell based on the cell internal resistance value calculated by the internal resistance value.

In the charging apparatus for the packed battery according to the present invention, the charging control means has an accumulation amount calculation means calculating a residual accumulation amount of the secondary cell based on the current value detected at the time of the charging, and based on a current value of discharged current.

In a second aspect of the present invention, a quality judging apparatus for a packed battery judges a quality of the packed battery in which a plurality of secondary cells are connected in series, and comprises: a voltage supply means supplying a predetermined charging voltage to the packed battery; a cell voltage value detection means detecting cell voltage values of the respective secondary cells constituting the packed battery; and a quality judgment means judging a quality of the packed battery. The charging control means comprises: a dispersion degree calculation means calculating a dispersion degree of the secondary cells based on the cell voltage values detected by the cell voltage value detection means; a maximum value specifying means specifying the maximum value of the cell voltage value based on the dispersion degree calculated by the dispersion degree calculation means; and a judging means judging whether or not the maximum value of the cell voltage value specified by the maximum value specifying means reaches a preset permissible cell voltage value.

In the quality judging apparatus for the packed battery according to the present invention, the cell voltage value detection means includes detecting terminals detecting terminal cell voltage values of the respective secondary cells constituting the packed battery. The cell voltage value of the secondary cell as a target to be detected is detected based on a potential difference between the terminal cell voltage value of the secondary cell as the target to be detected and the terminal cell voltage value of the secondary cell at the lower potential side of the secondary cell as the target to be detected.

The quality judging apparatus for the packed battery according to the present invention further comprises a current value detection means detecting a current value of current flowing in the packed battery. The charging control means comprises: a voltage value switch means switched to select whether the packed battery is charged with an external voltage or shut off from the external voltage; an internal resistance value calculation means calculating a cell internal resistance value based on the cell voltage value of the secondary cell detected by the cell voltage value detection means in the case that an external voltage having a predetermined external voltage value is impressed to the packed battery by the switching of the voltage value switch means, based on the cell voltage value of the secondary cell detected by the cell voltage value detection means in the case that the external voltage is isolated from the packed battery by the switching of the voltage value switch means, and based on the current value detected by the current value detection means; and a state-of-health calculation means calculating a state of health of the secondary cell based on the cell internal resistance value calculated by the cell internal resistance value.

Effect of the Invention

Due to the charging apparatus for the packed battery in the first aspect of the present invention, the reduction of charging/discharging performance at the charge of the packed battery is prevented so as to secure reliability and safety of the packed battery.
Furthermore, by providing the detecting terminal for each of the secondary cells, the cell voltage value of each secondary cell can be detected easily so that the dispersion of the secondary cells in quality can be judged easily.
Furthermore, the charging can be performed without overcharging, and the health degree which is an indicator indicating the progress of deterioration of the secondary cell such as the packed battery in the case that the highest charge voltage is impressed is calculated so that a user can recognize exchange timing of the whole packed battery. Accordingly, sudden defect of the packed battery is prevented so as to improve reliability and safety of the packed battery. Furthermore, by detecting the change of the residual accumulation amount of the packed battery successively from the first, the charge period of the packed battery can be judged easily from the residual accumulation amount.

Due to the quality judging apparatus of the packed battery in the second aspect of the present invention, the reduction of charging/discharging performance at the charge of the packed battery is prevented so as to secure reliability and safety of the packed battery.

Furthermore, by providing the detecting terminals for the respective secondary cells, the cell voltage values of the respective secondary cell can be detected easily so that the dispersion of the secondary cells in quality can be judged easily.

Furthermore, a user can recognize a timing for exchanging the whole packed battery from the view of the state of health of the secondary cell to which the highest charge voltage is impressed, whereby the reliability and safety of the packed battery is improved.

Brief Description of Drawings

[Fig. 1] It is a block diagram of a charging apparatus according to an embodiment of the present invention.
[Fig. 2] It is a circuit diagram of a packed battery.
[Fig. 3] It is a flow chart of charging control.
[Fig. 4] It is a flow chart of charging control.
[Fig. 5] It is a flow chart of charging control based on cell voltage values.
[Fig. 6] It is a flow chart of calculation of a state of health based on internal resistance.
[Fig. 7] It is a block diagram of a quality judging apparatus.
[Fig. 8] It is a flow chart of quality judgment.
[Fig. 9] It is a flow chart of quality judgment based on cell voltage values.
[Fig. 10] It is a flow chart of calculation of a state pf health based on internal resistance.

The Best Mode for Carrying out the Invention

Next, explanation will be given on the best mode for carrying out the invention with reference to drawings.

**Embodiment 1**

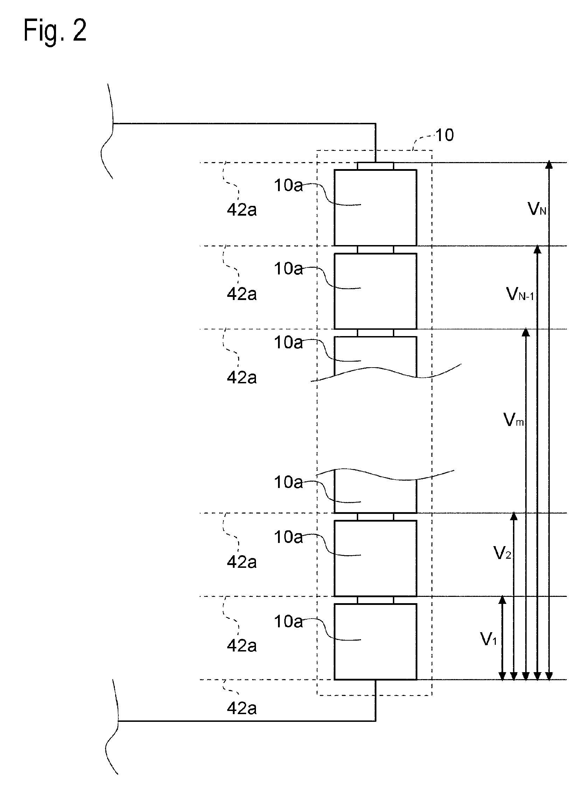

Explanation will be given on a charging apparatus 40 for a packed battery 10 in which secondary cells 10a are connected to one another in series. In the packed battery 10 used in this embodiment, ten secondary cells 10a are connected in series (see Fig. 2).

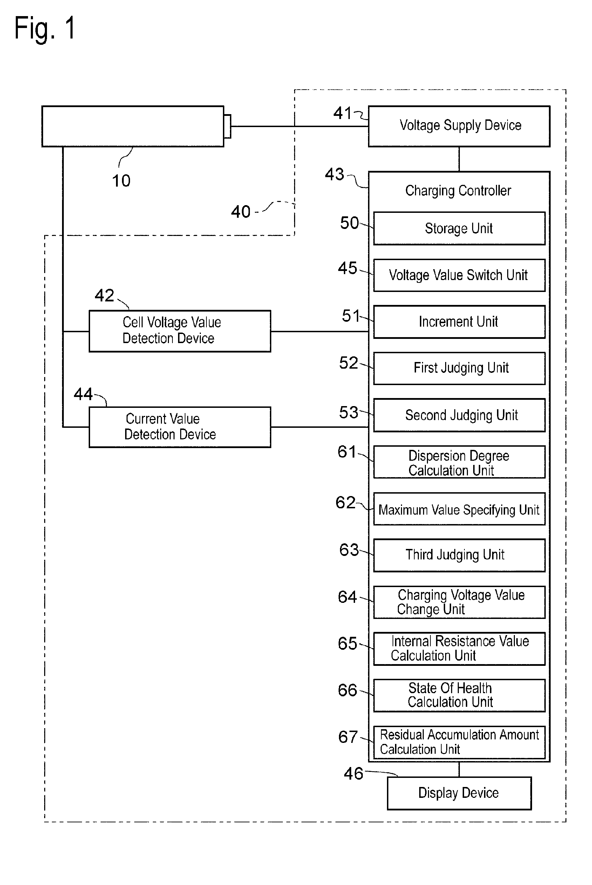

As shown in Fig.1, the charging apparatus 40 has a voltage supply device 41, a cell voltage value detection device 42, a charging controller 43, a current value detection device 44 and a display device 46. The voltage supply device 41 supplies a predetermined charging voltage to the packed battery 10. The cell voltage value detection device 42 detects cell voltage values $v_m$ of the respective secondary cells 10a constituting the packed battery 10.

The charging controller 43 controls the charging voltage supplied to the packed battery 10. The current value detection device 44 detects a current value J. The display device 46 displays an SOH (State Of Health), a residual accumulation amount $Q_{acum}$ and the like.

The SOH is an indicator which indicates the progress of deterioration of a secondary cell that may be provided in the packed battery 10, for example, and the SOH is generally defined as a ratio of "actual accumulation capacity" to "initial accumulation capacity". Since the product of the accumulation capacity and internal resistance is constant, the indicator is defined in the present application as an inverse ratio of "actual internal resistance value of the secondary cell" to "initial internal resistance value".

Next, explanation will be given on the charging controller 43.

As shown in Fig.1, the charging controller 43 has a storage unit 50, a voltage value switch unit 45, an increment unit 51, a first judging unit 52, a second judging unit 53, a dispersion degree calculation unit 61, a maximum value specifying unit 62, a third judging unit 63, a charging voltage value change unit 64, an internal resistance value calculation unit 65, a state-of-health (SOH) calculation unit 66 and a residual accumulation amount calculation unit 67.

The charging controller 43 includes a CPU performing various processes, a memory in which programs and the like are stored, and the like.

The storage unit 50 stores therein a minimum value of check voltage value $E_c$, which is smaller than a full-charge balanced voltage value $E_{eq}$, a predetermined charging voltage value $E_a$, which is larger than the full-charge balanced voltage value $E_{eq}$ and is smaller than an irreversible chemical reaction region, and a voltage value $\Delta E$ defining a predetermined increment.

The voltage value switch unit 45 switches the charging voltage applied to the packed battery 10 between the predetermined charging voltage value $E_a$, which is larger than the full-charge balanced potential value $E_{eq}$ and smaller than the irreversible chemical reaction region, and the check voltage value $E_c$, which is determined in correspondence to the full-charge balanced potential value $E_{eq}$.

The increment unit 51 adds the voltage value $\Delta E$ of the predetermined increment to the check voltage value $E_c$ of the previously impressed check voltage so as to set a new check voltage value $E_c$, and the first judging unit 52 judges whether or not the current value J detected by the current value J detection device 44 becomes not more than a previously inputted criterion value $J_c$.

The second judging unit 53 judges whether or not the time between the last affirmative judgment by the first judging unit 52 and the present affirmative judgment by the first judging unit 52 is longer than r-times (r is a real number not less than 1) as long as the time between the second last affirmative judgment and the last affirmative judgment.

The dispersion degree calculation unit 61 calculates a dispersion degree $\sigma$ of the secondary cells 10a based on the respective cell voltage values $v_m$ detected by the cell voltage value detection device 42. The dispersion degree $\sigma$ expresses a dispersion of the secondary cells 10a in quality calculated based on the voltage values thereof.

The maximum value specifying unit 62 specifies a maximum charge-on cell voltage value $v_{maxon}$, which is a maximum of a charge-on cell voltage value $v_{mon}$ that is a cell voltage value during impression of the charging voltage, based on the dispersion degree $\sigma$ of the secondary cells calculated by the dispersion degree calculation unit 61.

The third judging unit 63 judges whether or not the maximum charge-on cell voltage value $v_{maxon}$ specified by the maximum value specifying unit 62 is larger than a preset permissible cell voltage value $v_c$.

The charging voltage value change unit 64 changes the charging voltage value $E_a$ of the charging voltage impressed by the voltage supply device 41 based on the voltage difference between the maximum charge-on cell voltage value $v_{maxon}$ and the permissible cell voltage value $v_c$ when the third judging unit 63 judges that the maximum charge-on cell voltage value $v_{maxon}$ is larger than the permissible cell voltage value $v_c$.

The internal resistance value calculation unit 65 calculates a cell internal resistance value $R_m$ of the secondary cell 10a based on the charge-on cell voltage value $v_{mon}$ of the secondary cell 10a detected by the cell voltage value detection device 42 in the case that the charging voltage is impressed at the charging voltage value $E_a$ to the packed battery 10 by the switching of the voltage value switch unit 45, based on a closed-circuit cell voltage value $v_{moff}$ of the secondary cell 10a detected by the cell voltage value detection device 42 in the case that a closed circuit is activated to impress the check voltage at the check voltage value $E_c$ to the packed battery 10 by the switching of the voltage value switch unit 45, and based on the current value J detected by the current value detection device 44.

The state-of-health calculation unit 66 calculates a cell state of health $SOH_m$ of the most deteriorated secondary cell 10M which indicates the maximum charge-on cell voltage value $v_{maxon}$ at the maximum value specifying unit 62, and calculates the cell state of health $SOH_m$ of the most deteriorated secondary cell 10M based on the cell internal resistance value $R_m$ of the most deteriorated secondary cell 10M calculated by the internal resistance value calculation unit 65.

The residual accumulation amount calculation unit 67 calculates the residual accumulation amount $Q_{acum}$ of the secondary cell 10a based on the current value J detected at the time of the accumulation, and based on a discharged current value $J_{out}$ detected at the time of the electric discharge.

Next, explanation will be given on the flow of accumulation of the packed battery 10 by the charging controller 43 according to the embodiment.

The charging controller 43 controls the accumulation of the packed battery 10 according to below steps.

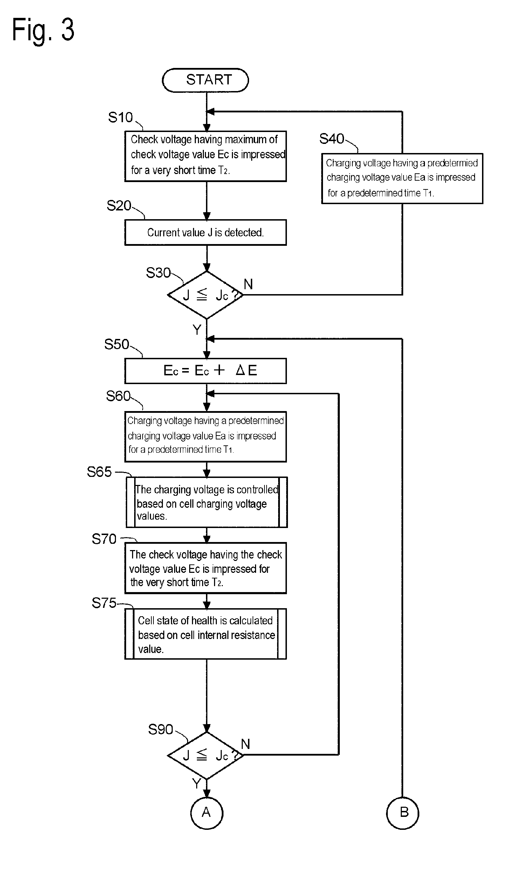

Firstly, as shown in Fig. 3, the check voltage having the minimum value of check voltage value $E_c$ is impressed to the packed battery 10 for a very short time $T_2$ (step S10), and for the very short time $T_2$, the current value J of current flowing in the packed battery 10 is detected by the current value detection device 44 (step S20).

Next, the detected current value J is judged by the first judging unit 52 (step S30), and when the current value J is larger than the criterion value $J_c$, the value of charging voltage is switched to the predetermined charging voltage value $E_a$ by the voltage value switch unit 45, so that the predetermined charging voltage value $E_a$ is impressed to the packed battery 10 for a predetermined time $T_1$ (step S40). Subsequently, the voltage of charging voltage is switched to the minimum value of check voltage value $E_c$ by the voltage value switch unit 45, and the control is returned to the step S10.

When the current value J is not more than the criterion value $J_c$, the voltage value $\Delta E$ of the predetermined increment is added to the check voltage value $E_c$ of the previously impressed check voltage by the increment unit 51 so as to set a new check voltage value $E_c$ (step S50).

Subsequently, the value of charging voltage is switched to the predetermined charging voltage value $E_a$ by the voltage value switch unit 45, and the charging voltage having the predetermined charging voltage value $E_a$ is impressed to the packed battery 10 for the predetermined time $T_1$ (step S60). At the step S60, while the charging voltage having the predetermined charging voltage value $E_a$ is impressed for the predetermined time $T_1$, the charging voltage control is performed based on the cell charging voltage values (step S65). Then, the voltage of charging voltage is switched to the new check voltage value $E_c$ by the voltage value switch unit 45, and the check voltage having the new check voltage value $E_c$ is impressed to the packed battery 10 for the very short time $T_2$ (step S70). For the very short time $T_2$, the cell state of health $SOH_m$ of the most deteriorated secondary cell 10M is calculated based on the cell internal resistance value $R_m$ of the most deteriorated secondary cell 10M (step S75).

Then, the detected current value J is judged by the first judging unit 52 (step S90). When the current value J is larger than the criterion value $J_c$, the control is returned to the step S10. When the current value J is not more than the criterion value $J_c$, the control is shifted to next step S100.

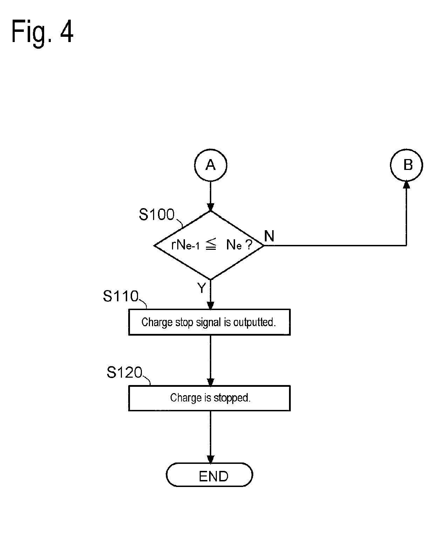

As shown in Fig. 4, at the step S100, the time between the last affirmative judgment and the present affirmative judgment by the first judging unit 52 is judged by the second judging unit 53. When the time $N_e$ between the last affirmative judgment and the present affirmative judgment and the present affirmative judgment by the first judging unit 52 is not longer than r-times as long as the time $N_{e-1}$ between the second last affirmative judgment and the last affirmative judgment, control is returned to the step S50 (see Fig 3). When the time $N_e$ between the last affirmative judgment and the present affirmative judgment and the present affirmative judgment by the first judging unit 52 is longer than r-times as long as the time $N_{e-1}$ between the second last affirmative judgment and the last affirmative judgment, a charge stop signal is outputted (step S110) and the charge of the packed battery 10 is stopped (step S120).

In the charging apparatus 40 of the embodiment, regardless of the type or model of the packed battery 10 (the secondary cell 10a), any packed battery 10 can be charged so as to seek the full-charge balanced voltage value $E_{eq}$ of the packed battery 10 for making the charging rate reach almost 100%. Even if a part of the internal structure of the packed battery 10 is broken and deteriorated, that is, even if any one of the secondary cells 10a constituting the packed battery 10 is broken, the device is effective so as to seek the actual full-charge balanced voltage value $E_{eq}$ of the packed battery 10 and to charge the battery in consideration of the actual charge capacity, thereby making the charging rate reach almost 100%.

Next, explanation will be given on the flow of the charging voltage control based on the cell voltage values performed at the step S65.

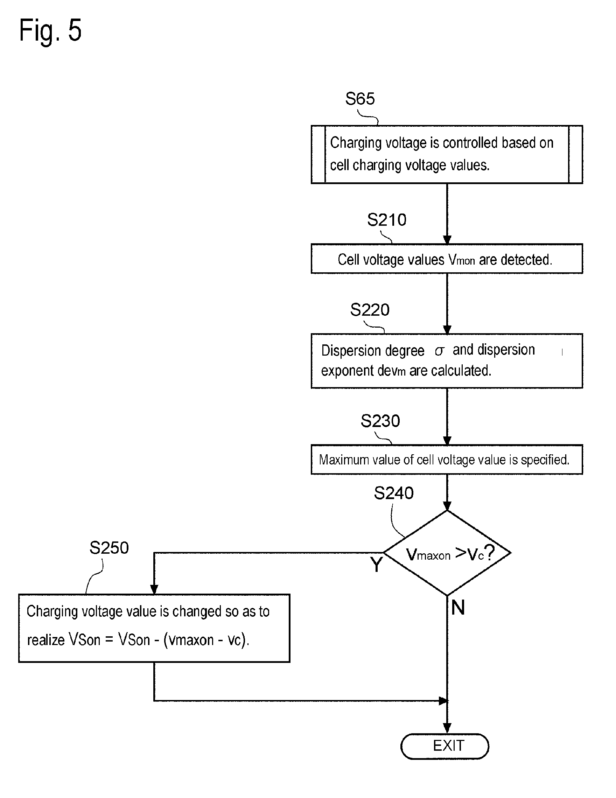

As shown in Fig. 5, the flow of the charging voltage control based on the cell voltage values is performed with below steps. Firstly, charge-on terminal cell voltage values $V_{mon}$ of the respective secondary cells 10a constituting the packed battery 10 are detected as the respective charge-on cell voltage values $v_{mon}$ (step S210).

Explanation will be given on a method for detecting the cell voltage value of each of the secondary cells 10a constituting the packed battery 10.

As shown in Fig. 2, the cell voltage value detection device 42 in the embodiment detecting terminals 42a which detect the respective charge-on cell voltage values $v_{mon}$ of the respective secondary cells 10a constituting the packed battery 10. By the detecting terminals 42a, a charge-on terminal cell voltage value $V_{1on}$ of one secondary cell 10a, a charge-on terminal cell voltage value $V_{2on}$ of two secondary cells 10a, ... and a charge-on terminal cell voltage value $V_{mon}$ of m-pieces ("m" is a real number which is not less than 1 and not more than N) of secondary cells 10a can be detected.

By employing the charge-on terminal cell voltage value $V_{mon}$, the charge-on cell voltage value $v_{mon}$ of each secondary cell 10a is calculated with Formula 1.

[Formula 1]

$$v_{mon} = V_{mon} - V_{(m-1)on}$$

As shown in Formula 1, in the cell voltage value detection device 42, based on a potential difference between the charge-on terminal cell voltage value $V_{mon}$ of the (m-count) secondary cell 10a serving as a detection target and the charge-on terminal cell voltage value $V_{(m-1)on}$ of the secondary cell 10a, which is disposed at the lower potential side of the secondary cell 10a serving as the detection target, the charge-on cell voltage value $v_{mon}$ of the (m-count) secondary cell 10a as the detection target is detected. Accordingly, the charge-on cell voltage value $v_{mon}$ of each secondary cell 10a can be detected easily so that the dispersion of the secondary cells 10a in quality can be judged easily.

Since the charge-on terminal cell voltage value $V_{Non}$ of N-pieces of secondary cells 10a is equal to the full charge-on terminal cell voltage value of the whole pack packed battery 10, which is referred to as $V_{Son}$, the full charge-on terminal cell voltage value $V_{Son}$ is calculated with Formula 2.

[Formula 2]

$$VSon = VNon$$

Next, the dispersion degree $\sigma$ and a dispersion exponent $dev_m$ are calculated based on the charge-on cell voltage values $v_{mon}$ of the respective secondary cells 10a and an average charge-on voltage value $V_{MEANon}$ of the secondary cells 10a (step S220).

The average charge-on voltage value $V_{MEANon}$ of the secondary cells 10a is calculated with Formula 3.

[Formula 3]

$$V_{MEANon} = VSon/N$$

The dispersion degree $\sigma$ of the charge-on cell voltage values $v_{mon}$ of the respective secondary cells 10a is calculated with Formula 4.

[Formula 4]

$$\sigma = \sqrt{\frac{1}{N}\sum_{m=1}^{N}\left(v_{mon}^2 - V_{MEANon}^2\right)}$$

The dispersion exponent $dev_m$ is calculated with Formula 5 from the dispersion degree $\sigma$, the average charge-on voltage value $V_{MEANon}$ and the charge-on cell voltage value $v_{mon}$ of the respective secondary cell 10a. The dispersion exponent $dev_m$ indicates a dispersion of each of the secondary cells 10a in quality.

[Formula 5]

$$dev_m = \frac{10 \times \left(v_{mon} - V_{MEANon}\right)}{\sigma} + 50$$

Next, the maximum value of the cell voltage value is specified from the dispersion exponent $dev_m$ calculated at the step S220 by the maximum value specifying unit 62 based on the dispersion degree $\sigma$ of the secondary cells 10a calculated by the dispersion degree calculation unit 61 (step S230).

At this step, the dispersion exponents $dev_m$ of the respective secondary cells 10a calculated at the step S220 are compared with one another so as to specify the maximum charge-on cell voltage value $v_{maxon}$ which brings the maximum dispersion exponent $dev_m$. The most deteriorated secondary cell 10M indicating the maximum charge-on cell voltage value $v_{maxon}$ is the secondary cell 10a whose cell internal resistance value $R_m$ is different from those of the other secondary cells 10a, that is, the most deteriorated secondary cell 10M is very possible to be deteriorated and to cause overcharge.

Next, the third judging unit 63 judges whether or not the maximum charge-on cell voltage value $v_{maxon}$ specified by the maximum value specifying unit 62 is larger than the permissible cell voltage value $v_c$ (step S240).

When the maximum charge-on cell voltage value $v_{maxon}$ is judged to be larger than the permissible cell voltage value $v_c$, the charging voltage value change unit 264 changes the predetermined charging voltage value $E_a$ of charging voltage impressed by the voltage supply device 41 based on the voltage difference between the maximum charge-on

cell voltage value $v_{maxon}$ and the permissible cell voltage value $v_c$, so as to reduce the full charge-on cell voltage value $V_{Son}$ according to Formula 6 (step S250).

[Formula 6]

$$V_{Son} = V_{Son} - (V_{maxon} - V_c)$$

Subsequently, the charging voltage control based on the cell voltage values is finished. When the maximum charge-on cell voltage value $v_{maxon}$ is judged to be not more than the permissible cell voltage value $v_c$, the charging voltage control based on the cell voltage values is finished.

Incidentally, the permissible cell voltage value $v_c$ is prescribed about each of kinds of secondary cells. For example, the permissible cell voltage value $v_c$ of a lithium-ion battery is prescribed to be 4.2V.

Next, explanation will be given on a flow of calculation of the cell state of health $SOH_m$ of the most deteriorated secondary cell 10M at the step S75.

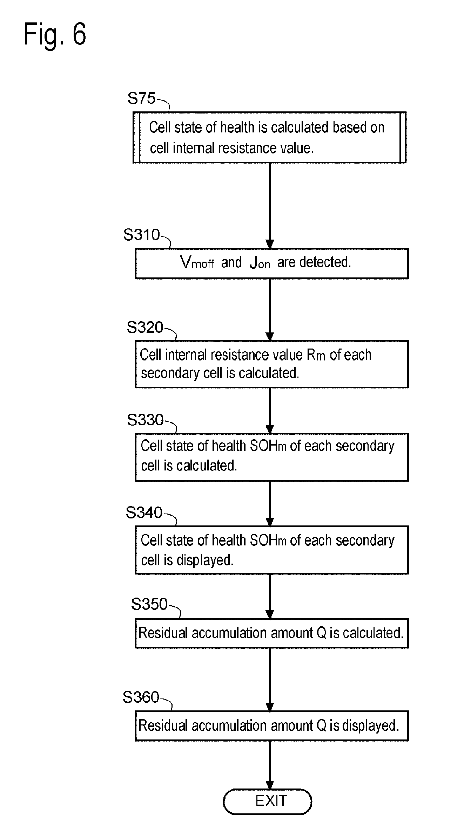

The calculation of the cell state of health $SOH_m$ of the most deteriorated secondary cell 10M is performed with below steps. Firstly, as shown in Fig. 6, the closed-circuit cell voltage value $v_{moff}$ and the current value J are detected (step S310). The closed-circuit cell voltage value is calculated from closed-circuit terminal cell voltage values $V_{moff}$ and $V_{(m-1)off}$ with Formula 3. The current value J is detected by the current value detection device 44.

Next, the cell internal resistance value $R_m$ is calculated by the internal resistance value calculation unit 65 (step S320). The cell internal resistance value $R_m$ is calculated with Formula 7.

[Formula 7]

$$R_m = \Delta v_m / I$$

The secondary cell 10a serving as a target of calculation of the cell internal resistance value $R_m$ is the most deteriorated secondary cell 10M indicating the maximum dispersion exponent $dev_m$. Instead of the most deteriorated secondary cell 10M, any of the secondary cells 10a may be optionally employed as the target.

At the time of the first charge, an initial cell internal resistance value $R_{mint}$ is calculated.

$\Delta v_m$ is the voltage difference between the charge-on cell voltage value $v_{mon}$ of each secondary cell 10a and the closed-circuit cell voltage value $v_{moff}$ of each secondary cell 10a, and is calculated with Formula 8.

[Formula 8]

$$\Delta v_m = v_{mon} - v_{moff}$$

Next, the cell state of health $SOH_m$, serving as an indicator which indicates the progress of deterioration of the secondary cell 10a is calculated by the SOH calculation unit 66 (step S330).

The cell state of health $SOH_m$ is an indicator which indicates the progress of deterioration of the secondary cell 10a, and is defined as a ratio of the present charge capacity to the initial charge capacity. Since the product of the charge capacity and the internal resistance is constant, the cell state of health $SOH_m$ is defined as an inverse ratio of the cell internal resistance value $R_m$ to an initial cell internal resistance value $R_{mint}$, and can be calculated with Formula 9.

[Formula 9]

$$SOH_m = R_{mint} / R_m \times 100$$

Accordingly, by calculating the initial cell internal resistance value $R_{mint}$ previously, the cell state of health $SOH_m$ can be calculated from the cell internal resistance value $R_m$.

At the time of the first charge, the initial cell internal resistance value $R_{mint}$ is substituted for the cell internal resistance value $R_m$, so that the cell state of health $SOH_m$ is 100.

Then, the cell state of health SOH calculated at the step S330 is displayed by the display device 46 (step S340).

The cell internal resistance value $R_m$ of each secondary cell 10a is substantially constant until the closing period of charge. At the closing period of charge, the cell internal resistance value $R_m$ generally becomes larger following irreversible chemical reaction of the secondary cell. Therefore, when the charge rate is about 70% at the most, the cell internal resistance value $R_m$ of each secondary cell 10a can be calculated accurately.

In the embodiment, the cell internal resistance value $R_m$ is calculated from the charge-on cell voltage value $v_{mon}$, the closed-circuit cell voltage value $v_{moff}$ and the current value J. However, a full charge-on voltage value $V_{Son}$, a full closed-circuit voltage value $V_{Soff}$ and the current value J may be substituted for corresponding algebras of Formulas 7 and 8 so as to calculate a internal resistance value R of the whole packed battery 10, or the internal resistance value R and an initial internal resistance value $R_{int}$ may be substituted for corresponding algebras of Formula 9 so as to calculate a state of health SOH of the whole packed battery 10.

Next, the current value J detected at the step S210 is time-integrated by the residual accumulation amount calculation unit 67 so as to calculate the residual accumulation amount $Q_{acum}$ of the packed battery 10 (step S350).

The residual accumulation amount $Q_{acum}$ is equal to an integrated value $Q_{charge}$ of time integration of the current value J of the packed battery 10.

Then, the residual accumulation amount $Q_{acum}$ calculated at the step S350 is displayed by the display device 46 (step S360).

As mentioned above, in the charging apparatus 40 of the embodiment, the most deteriorated secondary cell 10M to which the most part of the charging voltage having the predetermined charging voltage value $E_a$ is impressed is specified from all the secondary cells 10a constituting the packed battery 10, and the charge of the packed battery 10 can be performed while the predetermined charging voltage value $E_a$ of the part of charging voltage impressed to the most deteriorated secondary cell 10M is maintained to be not more than a certain value. Not the respective charge-on cell voltage values $v_{mon}$ of the secondary cells 10a, but the full charge-on voltage value $V_{Son}$ of the packed battery 10 is controlled, whereby the charging/discharging ability of the packed battery 10 to be charged is prevented from being reduced, thereby securing reliability and safety of the packed battery 10. The charge control is made easy so that production cost is reduced.

The degree of deterioration of any one of the secondary cells 10a constituting the packed battery 10 can be found from time-dependent change of the cell internal resistance value $R_m$ so that a user can recognize a timing for exchanging the whole packed battery 10. Accordingly, the packed battery 10 is prevented from suddenly breaking down, thereby improving reliability and safety of the packed battery 10.

Namely, in the case that the cell state of health $SOH_m$ is low, when the SOH of the whole packed battery 10 is high, it is very possible that only the most deteriorated secondary cell 10M indicating the low cell state of health $SOH_m$ is deteriorated. On the contrary, when the SOH of the whole packed battery 10 is low, it is very possible that the packed battery 10 is entirely deteriorated.

Furthermore, by successively detecting the change of the residual accumulation amount $Q_{acum}$ of the packed battery 10 from the original state, the period for charging the packed battery 10 can be judged easily from the residual accumulation amount $Q_{acum}$.

The charging apparatus 40 of the present embodiment may be adapted to an electric car equipped with a charging equipment, for example, which serves as an apparatus reservably set with the packed battery 10. In such a construction, the change of the residual accumulation amount $Q_{acum}$ of the packed battery 10 can be detected successively from the original state.


**Embodiment 2**


Next, explanation will be given on a checker 200 as a quality judgment apparatus judging the quality of the packed battery 10 in which a plurality of the secondary cells 10a are connected in series.

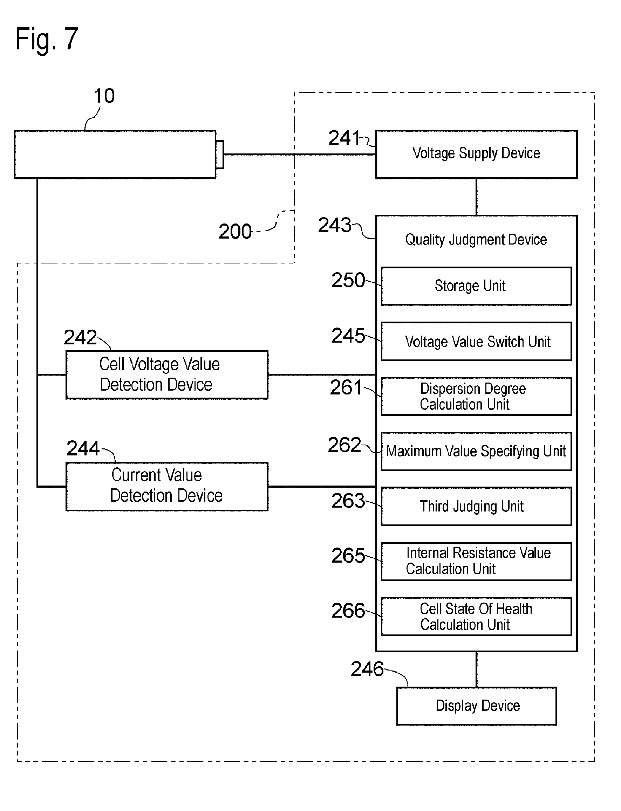

As shown in Fig. 7, the checker 200 includes a voltage supply device 241, a cell voltage value detection device 242, a quality judgment device 243, a current value detection device 244 and a display device 246.

The voltage supply device 241 supplies a predetermined external voltage to the packed battery 10.

The voltage value detection device 242, the current value detection device 244 and the display device 246 are respectively constructed similarly to the voltage value detection device 42, the current value detection device 44 and the display device 46 in the above-mentioned embodiment (see Fig. 1), and therefore, detailed explanation thereof is omitted.

Next, explanation will be given on the quality judgment device 243.

As shown in Fig. 7, the quality judgment device 243 judges the quality of the packed battery 10 and includes a CPU performing various processes, a memory in which program and the like are stored, and the like. Concretely, the quality judgment device 243 includes a storage unit 250, a voltage value switch unit 245, a dispersion degree calculation unit 261, a maximum value specifying unit 262, an internal resistance value calculation unit 265 and a state-of-health (SOH) calculation unit 266.

The storage unit 250 stores therein the permissible cell voltage value $v_c$ of the secondary cell 10a.

The voltage value switch unit 245 is switched to select whether the packed battery 10 is charged with the external voltage or is shut off from the external voltage.

The dispersion degree calculation unit 261, the maximum value specifying unit 262, the internal resistance value calculation unit 265 and the state-of-health calculation unit 266 are respectively constructed similarly to the dispersion degree calculation unit 61, the maximum value specifying unit 62, the internal resistance value calculation unit 65 and the state-of-health calculation unit 66 in the above-mentioned embodiment (see Fig. 1), and therefore, detailed explanation thereof is omitted.

Next, explanation will be given on the flow of quality judgment by the quality judgment device 243.

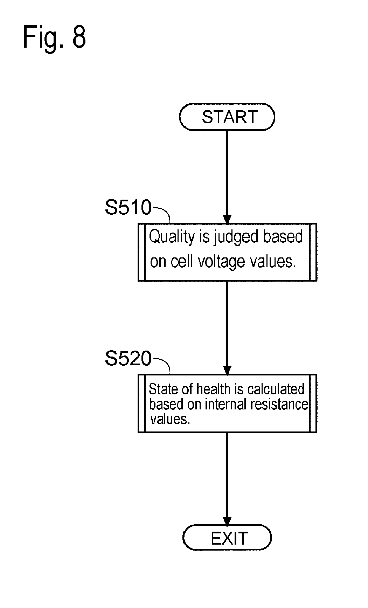

Firstly, as shown in Fig. 8, the voltage value switch unit 245 is turned "ON" so that the external voltage is impressed by the voltage supply device 241 and the quality judgment is performed based on the cell voltage values (step S510). Then, the voltage value switch unit 245 is turned "OFF" so as to shut off the external voltage, and the cell state of health $SOH_m$ of the most deteriorated secondary cell 10M is calculated from the cell internal resistance value $R_m$ of the most deteriorated secondary cell 10M (step S520).

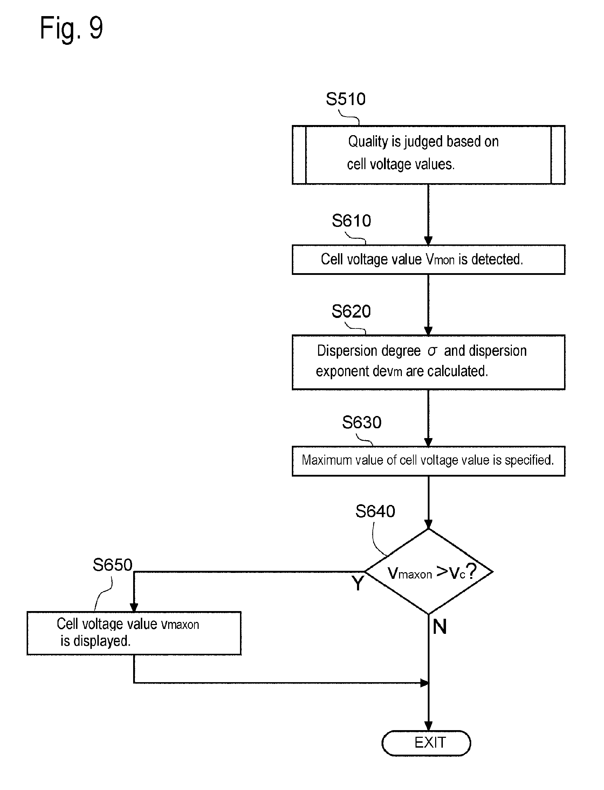

As shown in Fig. 9, the quality judgment based on the cell voltage value is performed with below steps.

Firstly, the charge-on cell voltage value $v_{mon}$ is detected from the charge-on terminal cell voltage value $V_{mon}$ of each of the secondary cells 10a (step S610).

The method for detecting the cell voltage values of the respective secondary cells 10a constituting the packed battery 10 in this case is similar to the method for detecting the cell voltage values according to the above-mentioned embodiment (see Fig. 5). The charge-on cell voltage value $v_{mon}$ of each secondary cell 10a is detected with Formula 1 and the full charge-on voltage value $V_{Son}$ of the packed battery 10 is calculated with Formula 2.

Next, by the dispersion degree calculation unit 261, the dispersion degree $\sigma$ and the dispersion exponent $dev_m$ are calculated from the charge-on cell voltage value $v_{mon}$ and the average charge-on voltage value $V_{MEANon}$ of each secondary cell 10a.

The calculation methods of the average charge-on voltage value $V_{MEANon}$, the dispersion degree $\sigma$ and the dispersion exponent $dev_m$ in this case are similar to the calculation method of the above-mentioned embodiment (see Fig. 5). The average charge-on voltage value $V_{MEANon}$, the dispersion degree $\sigma$ and the dispersion exponent $dev_m$ are calculated respectively with Formulas 3, 4 and 5.

Next, by the maximum value specifying unit 262, based on the dispersion degree $\sigma$ of the secondary cell 10a calculated by the dispersion degree calculation unit 261, the maximum of the cell voltage value is specified from the dispersion exponent $dev_m$ calculated at the step S620 (step S630).

The dispersion exponent $dev_m$ of each secondary cell 10a calculated at the step S620 is compared with each other so as to specify the maximum charge-on cell voltage value $v_{maxon}$ of the most deteriorated secondary cell 10M indicating the maximum dispersion exponent $dev_m$.

The most deteriorated secondary cell 10M indicating the maximum charge-on cell voltage value $v_{maxon}$ is the secondary cell 10a whose cell internal resistance value $R_m$ is different from those of the other secondary cells 10a, that is, the most deteriorated secondary cell 10M is very possible to be deteriorated and to cause overcharge.

Next, the fourth judging unit 263 judges whether or not the maximum charge-on cell voltage value $v_{maxon}$ specified by the maximum value specifying unit 262 is larger than the preset permissible cell voltage value $v_c$ (step S640).

When the maximum charge-on cell voltage value $v_{maxon}$ is judged to be larger than the permissible cell voltage value $v_c$, the maximum charge-on cell voltage value $v_{maxon}$ of the most deteriorated secondary cell 10M is displayed by the display device 246 (step S650). At this time, the display device 246 may display a warning of the deterioration of the secondary cell 10a for user's notice in addition to the display of the maximum charge-on cell voltage value $v_{maxon}$. Subsequently, the quality judgment based on the cell voltage values is finished. When the maximum charge-on cell voltage value $v_{maxon}$ is judged to be not more than the permissible cell voltage value $v_c$, the quality judgment based on the cell voltage value is finished.

Next, as shown in Fig. 8, the cell state of health $SOH_m$ of the most deteriorated secondary cell 10M is calculated from the cell internal resistance value $R_m$ of the most deteriorated secondary cell 10M (step S520).

The calculation of the cell state of health $SOH_m$ of the most deteriorated secondary cell 10M is performed with below steps.

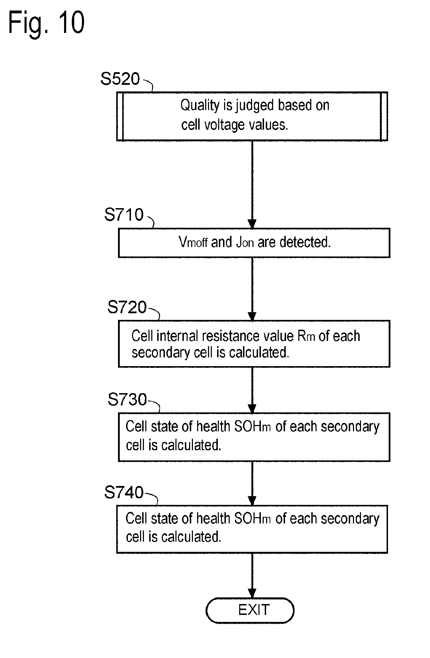

Firstly, as shown in Fig. 10, the shut-off cell voltage value $v_{mshut}$ and the current value J are detected (step S710).

The shut-off cell voltage value $v_{mshut}$ is calculated with formula 1 from shut-off terminal cell voltage values $V_{mshut}$ and $V_{(m-1)\,shut}$. The current value J is detected by the current value detection device 44.

Next, by the internal resistance value calculation unit 265, the cell internal resistance value $R_m$ is calculated

(step S720). The cell internal resistance value $R_m$ is calculated with Formula 7 by the same calculation method as the above-mentioned embodiment (see Fig. 6).

The secondary cell 10a as a target of calculation of the cell internal resistance value $R_m$ is the most deteriorated secondary cell 10M indicating the maximum dispersion exponent $dev_m$. Instead of the most deteriorated secondary cell 10M, any of the secondary cells 10a may be optionally employed as the target.

At the time of the first charge, the initial cell internal resistance value $R_{mint}$ is calculated with Formula 7.

$\Delta v_m$ in Formula 7 is the voltage difference between the charge-on cell voltage value $v_{mon}$ of each secondary cell 10a and the shut-off cell voltage value $v_{mshut}$ of each secondary cell 10a, and is calculated with Formula 10.

[Formula 10]

$$\Delta V_m = V_{mon} - V_{mshut}$$

Next, the cell state of health $SOH_m$ serving as an indicator which indicates the progress of deterioration of the secondary cell 10a is calculated by the state-of-health calculation unit 266 (step S730).

The cell state of health $SOH_m$ is an indicator which indicates the progress of deterioration of the secondary cell 10a, and is defined as a ratio of the present charge capacity to the initial charge capacity. Since the product of the charge capacity and the internal resistance is constant, the cell state of health $SOH_m$ is defined as an inverse ratio of the cell internal resistance value $R_m$ to the initial cell internal resistance value $R_{mint}$, and can be calculated with Formula 9.

In the present embodiment, the cell internal resistance value $R_m$ is calculated from the charge-on cell voltage value $v_{mon}$, the shut-off cell voltage value $v_{mshut}$ and the current value J. However, the full charge-on voltage value $V_{Son}$, the full shut-off voltage value $V_{Sshut}$ and the current value J may be substituted for corresponding algebras of Formulas 7 and 10 so as to calculate the internal resistance value R of the whole packed battery 10, or the internal resistance value R and the initial internal resistance value $R_{int}$ may be substituted for corresponding algebras of Formula 9 so as to calculate the state of health SOH of the whole packed battery 10.

Then, the cell state of health $SOH_m$ is displayed by the display device 246 (step S740). Subsequently, the calculation of the cell state of health $SOH_m$ of the most deteriorated secondary cell 10M is finished.

As mentioned above, the checker 200 in the present embodiment is constructed so as to judge whether or not the maximum charge-on cell voltage value $v_{maxon}$ larger than the permissible cell voltage value $v_c$ exists in the secondary cells 10a constituting the packed battery 10. Accordingly, the charging/discharging ability of the packed battery 10 to be charged is prevented from being reduced, thereby securing reliability and safety of the packed battery 10. The dispersion degree σ and the maximum charge-on cell voltage value $v_{maxon}$ can lead to judge whether the packed battery 10 is entirely deteriorated or any of the secondary cells 10a is deteriorated.

A user can recognize a timing for exchanging the whole packed battery 10 from the state of health of the whole packed battery 10. Accordingly, the packed battery 10 is prevented from suddenly breaking down, thereby improving reliability and safety of the packed battery 10.

Industrial Applicability

The charging apparatus and quality judging apparatus of packed battery according to the present invention can be employed suitably for a charging apparatus which charges a packed battery in which a plurality of secondary cells are connected in series.

**Claims**

1. A charging apparatus for charging a packed battery, the packed battery including a plurality of secondary cells connected in series, and the charging apparatus comprising:

a voltage supply means supplying a predetermined charging voltage to the packed battery;
a cell voltage value detection means detecting cell voltage values of the respective secondary cells constituting the packed battery; and
a charging control means controlling the charging voltage supplied to the packed battery,
**characterized in that** the charging control means comprises:

a dispersion degree calculation means calculating a dispersion degree of the secondary cells based on the cell voltage value detected by the cell voltage value detection means;

a maximum value specifying means specifying the maximum value of the cell voltage value based on the dispersion degree calculated by the dispersion degree calculation means;

a judging means judging whether or not the maximum value of the cell voltage value specified by the maximum value specifying means is larger than a preset permissible cell voltage value; and

a charging voltage value change means changing a value of the charging voltage impressed by the voltage supply means based on a voltage difference between the maximum value of the cell voltage value and the permissible cell voltage value when the judging means judges that the maximum value of the cell voltage value is larger than the permissible cell voltage value.

2. The charging apparatus for the packed battery according to claim 1,
wherein the cell voltage value detection means detecting terminals detecting terminal cell voltage values of the respective secondary cells constituting the packed battery, and
wherein the cell voltage value of the secondary cell as a target to be detected is detected based on a potential difference between the terminal cell voltage value of the secondary cell as the target to be detected and the terminal cell voltage value of the secondary cell at the lower potential side of the secondary cell as the target to be detected.

3. The charging apparatus for the packed battery according to claim 1 or 2, further comprising:

a current value detection means detecting a current value of current flowing in the packed battery,
wherein the charging control means comprises:

a voltage value switch means switching the charging voltage for the packed battery between a predetermined charging voltage value, which is larger than a full-charge balanced voltage value and smaller than an irreversible chemical reaction region, and a check voltage value determined in correspondence to the full-charge balanced voltage value;

an internal resistance value calculation means calculating an internal resistance value based on the cell voltage value of the secondary cell detected by the cell voltage value detection means in the case that the charging voltage having a predetermined charging voltage value is impressed to the packed battery by the switching of the voltage value switch means, the cell voltage value of the secondary cell detected by the cell voltage value detection means in the case that the check voltage having the check voltage value is impressed to the packed battery by the switching of the voltage value switch means, and the current value detected by the current value detection means; and

a state-of-health calculation means calculating a state of health of the secondary cell based on the cell internal resistance value calculated by the internal resistance value.

4. The charging apparatus for the packed battery according to claim 3, wherein the charging control means has an accumulation amount calculation means calculating a residual accumulation amount of the secondary cell based on the current value detected at the time of the charging and a current value of discharged current.

5. A quality judging apparatus for judging a quality of a packed battery, the packed battery including a plurality of secondary cells connected in series, and the quality judging apparatus comprising:

a voltage supply means supplying a predetermined charging voltage to the packed battery;
a cell voltage value detection means detecting cell voltage values of the respective secondary cells constituting the packed battery; and
a quality judgment means judging a quality of the packed battery,
**characterized in that** the charging control means comprises:

a dispersion degree calculation means calculating a dispersion degree of the secondary cells based on the cell voltage values detected by the cell voltage value detection means;

a maximum value specifying means specifying the maximum value of the cell voltage value based on the dispersion degree calculated by the dispersion degree calculation means; and

a judging means judging whether or not the maximum value of the cell voltage value specified by the maximum value specifying means is larger than a preset permissible cell voltage value.

6. The quality judging apparatus for the packed battery according to claim 5,

wherein the cell voltage value detection means including detecting terminals detecting terminal cell voltage values of the respective secondary cells constituting the packed battery, and

wherein the cell voltage value of the secondary cell as a target to be detected is detected based on a potential difference between the terminal cell voltage value of the secondary cell as the target to be detected and the terminal cell voltage value of the secondary cell at the lower potential side of the secondary cell as the target to be detected.

7. The quality judging apparatus of the packed battery according to claim 5 or 6, further comprising:

a current value detection means detecting a current value flowing in the packed battery,
wherein the charging control means comprises:

a voltage value switch means switched to select whether the packed battery is charged with an external voltage or shut off from the external voltage;
an internal resistance value calculation means calculating a cell internal resistance value based on the cell voltage value of the secondary cell detected by the cell voltage value detection means in the case that an external voltage having a predetermined external voltage value is impressed to the packed battery by the switching of the voltage value switch means, the cell voltage value of the secondary cell detected by the cell voltage value detection means in the case that the external voltage is isolated from the packed battery by the switching of the voltage value switch means, and the current value detected by the current value detection means; and
a state-of-health calculation means calculating a state of health of the secondary cell based on the cell internal resistance value calculated by the cell internal resistance value.

## Fig. 1

Voltage Supply Device — 41

Charging Controller — 43

40

Storage Unit — 50

Voltage Value Switch Unit — 45

Cell Voltage Value Detection Device — 42

Increment Unit — 51

First Judging Unit — 52

Second Judging Unit — 53

Current Value Detection Device — 44

Dispersion Degree Calculation Unit — 61

Maximum Value Specifying Unit — 62

Third Judging Unit — 63

Charging Voltage Value Change Unit — 64

Internal Resistance Value Calculation Unit — 65

State Of Health Calculation Unit — 66

Residual Accumulation Amount Calculation Unit — 67

Display Device — 46

10

# Fig. 2

# Fig. 3

START

S10 Check voltage having maximum of check voltage value $E_c$ is impressed for a very short time $T_2$.

S40 Charging voltage having a predetermied charging voltage value $E_a$ is impressed for a predetermined time $T_1$.

S20 Current value $J$ is detected.

S30 $J \leqq J_c$ ?  N

Y

S50 $E_c = E_c + \Delta E$

S60 Charging voltage having a predetermined charging voltage value $E_a$ is impressed for a predetermined time $T_1$.

S65 The charging voltage is controlled based on cell charging voltage values.

S70 The check voltage having the check voltage value $E_c$ is impressed for the very short time $T_2$.

S75 Cell state of health is calculated based on cell internal resistance value.

S90 $J \leqq J_c$ ?  N

Y

A

B

Fig. 4

(A)                                   (B)

S100

$\lceil N_{e-1} \leqq N_e ?$   N

Y

S110  Charge stop signal is outputted.

S120  Charge is stopped.

END

# Fig. 5

S65

Charging voltage is controlled based on cell charging voltage values.

S210

Cell voltage values $V_{mon}$ are detected.

S220

Dispersion degree $\sigma$ and dispersion exponent $de_{vm}$ are calculated.

S230

Maximum value of cell voltage value is specified.

S240

$V_{maxon} > V_c?$

Y

N

S250

Charging voltage value is changed so as to realize $VS_{on} = VS_{on} - (v_{maxon} - v_c)$.

EXIT

# Fig. 6

S75

Cell state of health is calculated based on
cell internal resistance value.

S310

$V_{moff}$ and $J_{on}$ are detected.

S320

Cell internal resistance value $R_m$ of each
secondary cell is calculated.

S330

Cell state of health SOHm of each secondary
cell is calculated.

S340

Cell state of health SOHm of each secondary
cell is displayed.

S350

Residual accumulation amount Q is calculated.

S360

Residual accumulation amount Q is displayed.

EXIT

# Fig. 7

10

200

241 — Voltage Supply Device

243 — Quality Judgment Device

250 — Storage Unit

245 — Voltage Value Switch Unit

261 — Dispersion Degree Calculation Unit

262 — Maximum Value Specifying Unit

263 — Third Judging Unit

265 — Internal Resistance Value Calculation Unit

266 — Cell State Of Health Calculation Unit

242 — Cell Voltage Value Detection Device

244 — Current Value Detection Device

246 — Display Device

# Fig. 8

START

S510

Quality is judged based
on cell voltage values.

S520

State of health is calculated
based on internal resistance
values.

EXIT

# Fig. 9

S510

Quality is judged based on
cell voltage values.

S610

Cell voltage value Vmon is detected.

S620

Dispersion degree $\sigma$ and dispersion
exponent devm are calculated.

S630

Maximum value of cell voltage value is specified.

S640

$V_{maxon} > V_c$?

S650

Cell voltage value vmaxon
is displayed.

Y

N

EXIT

Fig. 10

S520

Quality is judged based on
cell voltage values.

S710

Vmoff and Jon are detected.

S720

Cell internal resistance value Rm of each
secondary cell is calculated.

S730

Cell state of health SOHm of each secondary
cell is calculated.

S740

Cell state of health SOHm of each secondary
cell is calculated.

EXIT

## INTERNATIONAL SEARCH REPORT

| | International application No. |
|---|---|
| | PCT/JP2008/053664 |

A. CLASSIFICATION OF SUBJECT MATTER
*H02J7/10(2006.01)i, G01R31/36(2006.01)i, H01M10/48(2006.01)i*

According to International Patent Classification (IPC) or to both national classification and IPC

B. FIELDS SEARCHED

Minimum documentation searched (classification system followed by classification symbols)
H02J7/10, G01R31/36, H01M10/48

Documentation searched other than minimum documentation to the extent that such documents are included in the fields searched
Jitsuyo Shinan Koho          1922-1996     Jitsuyo Shinan Toroku Koho     1996-2008
Kokai Jitsuyo Shinan Koho    1971-2008     Toroku Jitsuyo Shinan Koho     1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 06-133465 A  (Sanyo Electric Co., Ltd.), 13 May, 1994 (13.05.94), Par. Nos. [0014] to [0017]; Figs. 2 to 6 (Family: none) | 1-4 |
| A | JP 05-336674 A  (Toshiba Battery Co., Ltd.), 17 December, 1993 (17.12.93), Par. Nos. [0007], [0008]; Figs. 1, 2 (Family: none) | 1-4 |
| A | JP 2003-173823 A  (Sanyo Electric Co., Ltd.), 20 June, 2003 (20.06.03), Abstract; Fig. 1 & US 2003/085690 A1 | 5-7 |

☐  Further documents are listed in the continuation of Box C.          ☐  See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 01 May, 2008 (01.05.08) | 13 May, 2008 (13.05.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

24

**EP 2 249 455 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3913443 B
- JP 3539123 B
- JP 3430439 B
- JP 3752249 B